(19) Europäisches Patentamt

European Patent Office

Office européen des brevets

(11) **EP 0 647 020 B1**

(12) **EUROPÄISCHE PATENTSCHRIFT**

(45) Veröffentlichungstag und Bekanntmachung des Hinweises auf die Patenterteilung:
**15.12.1999 Patentblatt 1999/50**

(51) Int Cl.$^6$: **H03H 11/42**, H04H 7/00

(21) Anmeldenummer: **94113713.5**

(22) Anmeldetag: **01.09.1994**

(54) **Verstärkerschaltung mit einem asymmetrischen Eingang und einem symmetrischen Ausgang**

Amplifier circuit comprising an asymmetrical input and a symmetrical output

Circuit amplificateur comportant une entrée asymétrique et une sortie symétrique

(84) Benannte Vertragsstaaten:
**DE GB**

(30) Priorität: **01.09.1993 DE 4329505**

(43) Veröffentlichungstag der Anmeldung:
**05.04.1995 Patentblatt 1995/14**

(73) Patentinhaber: **WERKSTÄTTE FÜR STUDIO-TECHNIK Dipl.-Ing. Hellmut Haufe D-61250 Usingen (DE)**

(72) Erfinder: **Baudisch, Werner D-14089 Berlin (DE)**

(74) Vertreter: **Säger, Manfred, Dipl.-Ing. Postfach 41 7014 Trin (CH)**

(56) Entgegenhaltungen:
**DE-A- 3 832 293**

- **PATENT ABSTRACTS OF JAPAN vol. 017 no. 253 (E-1367) ,19.Mai 1993 & JP-A-04 372213 (IWAKI DENSHI KK) 25.Dezember 1992,**
- **HEWLETT-PACKARD JOURNAL, August 1980 PALO ALTO US, Seiten 12-13, GEORGE D. PONTIS 'Floating a Source Output'**

## Beschreibung

Das Patent betrifft eine Schaltungsanordnung gemäß dem Oberbegriff des Hauptanspruchs, vorteilhafte Weiterentwicklungen sind in den Unteransprüchen beschrieben.

In der professionellen Tonstudiotechnik war es in der Vergangenheit üblich, die Ein- und Ausgänge von Geräten mit symmetrischen und erdfreien Schnittstellen zu versehen, das heißt, an jedem Eingang eines Gerätes war ein Übertrager mit 2 Wicklungen angeordnet, dessen Sekundärwicklung mit der Masse des Gerätes verbunden war und dessen Primärwicklung von der Sekundärseite galvanisch getrennt war, und an jedem Ausgang eines Gerätes war ein Übertrager mit 2 Wicklungen angeordnet, dessen Primärwicklung mit der Masse des Gerätes verbunden war und dessen Sekundärwicklung von der Primärwicklung galvanisch getrennt war. Die Übertrager wurden so konstruiert, daß sie hohe Unsymmetriedämpfungen sowohl bezüglich der Widerstandsunsymmetrie als auch der Spannungsunsymmetrie aufwiesen. Die Meßverfahren für diese Unsymmetriedämpfungen der im folgenden zu betrachtenden Ausgangsübertrager sind in der IEC- Publikation 268-2 für die Spannungsunsymmetrie und im Pflichtenheft Nr. 3/5 für Tonregieanlagen der Öffentlich Rechtlichen Rundfunkanstalten der Bundesrepublik Deutschland , Ausgabe 10/1990, Anlage 1b, für die Widerstandsunsymmetrie beschrieben.

Dieses Verfahren der Verbindung von Tonquellen weist einen hohen Grad an Störsicherheit auf und zwar sowohl in Bezug auf die Eigenschaft der Verbindung als Störungsquelle als auch auf die Eigenschaft der Verbindung als Störungsempfänger. Durch die symmetrische Natur des Signals werden sowohl das elektrische als auch das magnetische Störungsfeld einer Verbindung weitgehend aufgehoben, Gleichtaktstörungen, denen die Verbindung ausgesetzt ist, werden um den Betrag der Unsymmetriedämfungen von Eingang oder Ausgang des gestörten Gerätes reduziert.

Ein weiterer Vorteil von Verbindungen mit symmetrisch erdfreien Schnittstellen ist die Tatsache, daß auch bei Verbindung einer Ausgangsader mit einer Masse, zum Beispiel in einem Fehlerfall, die Verbindung fast uneingeschränkt weiterfunktioniert. Dieser Vorteil trifft auch dann zu , wenn durch einen Fehlerfall eine Ausgangsader mit einem anderen pegelführenden Potential verbunden ist.

Weiterhin ist es mit symmetrischen und erdfreien Ein- oder Ausgangsschnittstellen problemlos möglich, diese mit unsymmetrischen Ein- oder Ausgängen zu verbinden. Dieser Vorteil gewinnt insofern an Bedeutung, als es im Bereich der Konsumelektronik sowie in der semiprofessionellen Audioelektronik Geräte mit unsymmetrischen Schnittstellen gibt, wobei diese Geräte oftmals Funktionen besitzen, die in professionellen Geräten noch nicht angeboten werden, weshalb diese Geräte auch in professionellen Systemen eingesetzt werden.

Den genannten Vorteilen stehen jedoch auch eine Reihe von Nachteilen gegenüber. So sind die verwendeten Übertrager als Wickelgüter relativ teuer, voluminös und schwer und begrenzen die verfügbare Bandbreite des Systems sowohl zu hohen als auch zu tiefen Frequenzen. Bei Übertragern mit magnetisierbaren Eisenkernen entstehen außerdem noch unerwünschte Verzerrungsprodukte.

Der Nachteil des hohen Volumens und des hohen Gewichts trifft insbesondere auf Ausgangsübertrager zu, speziell dann, wenn diese niedrige Frequenzen bei gleichzeitig hohen Pegeln übertragen sollen.

Es wurde daher auf verschiedene Weise versucht, Übertragerschnittstellen durch übertragerlose elektronische Lösungen zu ersetzen, wobei im folgenden nur der Ersatz von Ausgangsübertragern betrachtet werden soll, da dieser auch Gegenstand der Patentanmeldung ist.

Solche Stufen sind bekannt als symmetrische, nicht erdfreie Ausgangsstufen.

Im einfachsten Fall kann eine symmetrische Ausgangsstufe aus der Kombination eines Verstärkers ohne Phasenverschiebung und eines Verstärkers mit einer Phasenverschiebung von 180 Grad und gleichem Verstärkungsbetrag ersetzt werden, wodurch eine Stufe mit zwei um 180 Grad phasenverschobenen Signalen gleicher Amplitude entsteht. In " Walt Jung , Adolfo Garcia , Op-Amps in Line-Driver and Receiver Circuits, S 17, Analog Dialogue 27-1 (1993) ( Firmenschrift der Firma Analog Devices) " ist eine derartige Schaltung beschrieben, die bei Verwendung genügend eng tolerierter Bauteile die oben erwähnten Pflichtenheftforderungen bezüglich der Spannungs- sowie Widerstandsunsymmetrie erfüllt.

Diese Stufe kann somit bezüglich ihrer Störsicherheit als gleichwertig einer Ausgangsstufe mit Übertrager angesehen werden, allerdings fehlen ihr die betriebsmäßigen Vorteile in den angegebenen Fehlerfällen. Außerdem ist ein Betrieb an einer unsymmetrischen Last nur eingeschränkt möglich, da hierbei der mit dem Masseanschluß der unsymmetrischen Last verbundene Ausgangsverstärkerzweig praktisch kurzgeschlossen wird, was einen starken Anstieg der Verlustleistung in dieser Stufe bewirkt. Außerdem wird durch den Kurzschluß eines Ausgangsverstärkerzweiges der Ausgangspegel um 6 dB reduziert.

Dieses unerwünschte Verhalten kann zum Beispiel dadurch beseitigt werden, daß dem aus den beiden phasenverschobenen Ausgängen gebildeten Ausgang der Gesamtschaltung eine sogenannte Symmetrierdrossel nachgeschaltet wird. Eine Symmetrierdrossel ist eine Drossel mit zwei identischen Wicklungen mit gleichem Wicklungssinn. Eine derartige Drossel hat im Idealfall für symmetrische Signale einen sehr kleinen Widerstand, für unsymmetrische Signale stellt sie einen hohen Widerstand dar, so daß sich am Ausgang der aus Ausgangsstufe und nachgeschalteter Symmetrierdrossel ein übertragerähnliches Gesamtverhalten einstellt.

Nachteilig an dieser Lösung ist, daß die verwendete Symmetrierdrossel so dimensioniert werden muß, wie ein Ausgangsübertrager mit einem um 6 dB verringerten Maximalpegel. Der hierdurch erreichbare Volumen- und Gewichtsreduzierung ist daher relativ gering.

In " G. Pontis , Floating a Source Output, Hewlett Packard Journal, August 1980 " wird eine Schaltung beschrieben, die keine Symmetrierdrossel verwendet und dennoch deren betriebsmäßige Vorteile besitzt . Hierbei wird mit einem Paar kreuzgekoppelter Differenzverstärker die Ausgangsspannung mit der doppelten Eingangsspannung verglichen und so nachgeregelt, daß beide Werte identisch sind. Diese Schaltung ist auch bei einseitigem Kurzschluß sowie bei unsymmetrischem Betrieb funktionsfähig. Im Betrieb an einer unsymmetrischen Last wird lediglich die maximal mögliche Ausgangsspannung der Stufe wird um den Faktor 2 reduziert.

Nachteilig an dieser Schaltung ist allerdings ihre hohe Anzahl von Widerständen, wodurch durch die Widerstandstoleranzen zunächst unmittelbar die Genauigkeit der Stufenverstärkungen bei gegebener Toleranz und mittelbar die erreichbaren Unsymmetriedämpfungswerte bei gegebenen Bauteiltoleranzen begrenzt werden. So gehen in die Berechnung der Widerstandsunsymmetriedämpfung insgesamt 10 Widerstandswerte ein, in die Berechnung der Spannungsunsymmetriedämpfung gehen insgesamt 12 Widerstandswerte ein. Zur Erreichung hoher Unsymmetriedämpfungswerte sind daher außerordentlich engtolerierte Widerstände erforderlich.

Weiterhin sind diese Widerstände zusätzliche Rauschquellen, die das Rauschverhalten der Gesamtschaltung ungünstig beeinflussen.

Zusätzlich wird durch die Kreuzkopplung der Verstärker jedem Ausgang das Rauschsignal des komplementären Ausgangs hinzuaddiert, was das Rauschverhalten der Schaltung weiter verschlechtert.

Der Erfindung liegt die Aufgabe zugrunde , eine Schaltungsanordnung gemäß dem Oberbegriff vorzuschlagen, die in Ihrer Wirkungsweise einer Ausgangsschaltungsanordnung mit einem Ausgangsübertrager bezüglich Ihrer Stör- und Betriebssicherheit möglichst nahekommt, mit mäßig engtolerierten Bauteilen hohe Unsymmetriedämpfungswerte erreicht, wenig rauscht und keinen voluminösen Übertrager benötigt.

Diese Aufgabe wird bei einer gattungsgemäßen Schaltungsanordnung gemäß dem Oberbegriff des Hauptanspruchs erfindungsgemäß durch dessen kennzeichnende Merkmale gelöst. Gegenüber vorbekannten Lösungen weist die Schaltungsanordnung eine geringe Anzahl von solchen Widerständen auf, welche die Unsymmetriedämpfungswerte der Schaltung beeinflussen.

Eine zur Funktion notwendige Symmetrierdrossel kann in einer kleinen und preiswerten Bauform realisiert werden.

Zweckmäßige Ausgestaltungen und Weiterbildungen der Erfindung sind in den Unteransprüchen gekennzeichnet.

Die Erfindung wird nun anhand der Figuren erläutert.

Es zeigt:

Figur 1        ein erstes Blockschaltbild der erfindungsgemäßen Schaltung;

Figur 2        das Blockschaltbild, ergänzt um die Innenwiderstände der Übertragerwicklungen und einen einseitig kurzgeschlossenen Lastwiderstand ;

Figur 3        das Blockschaltbild einer Ausführungsvariante;

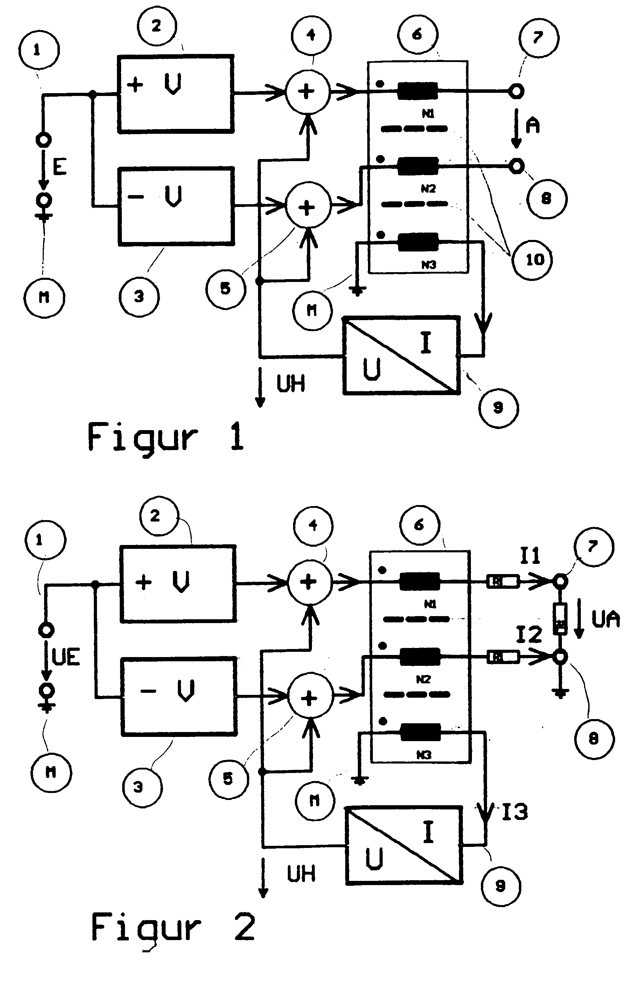

In der Schaltungsanordnung nach Figur 1 ist eine Schaltungsanordnung aus zwei Verstärkern (2), (3) mit gleichem Verstärkungsbetrag dargestellt, wobei der Verstärker (3) die Phase des Eingangssignals um 180 Grad dreht . Die Eingänge der Verstärker sind miteinander verbunden und werden von einem zwischen dem Eingangsanschluß (1) und Masse (M) liegenden Eingangssignal E gespeist.

Am Ausgang eines jeden Verstärkers liegt jeweils eine Additionsstufe (4) und (5) , welche die Summe aus dem Ausgangssignal des sie treibenden Verstärkers und einem aus einem Strom/Spannungs Wandler mit einer Übertragungsfunktion VIU stammenden Signal UH bildet.

Die Ausgangssignale der Additionsstufen führen an die Eingangsanschlüsse von 2 gleichen , vorzugsweise bifilar gewickelten Wicklungen N1 und N2 einer Symmetrierdrossel (6).

Die Ausgangsanschlüsse der beiden Wicklungen führen an die Klemmen (7) und (8), die den Ausgang A der Gesamtschaltung bilden.

Eine weitere, auf die Symmetrierdrossel aufgebrachte Wicklung N3, ist mit ihrem ersten Anschluß an Masse (M) angeschlossen , während ihr zweiter Anschluß in den Stromeingang eines Strom/Spannungs (I/U)- Wandlers (9) führt, dessen Ausgang mit dem jeweils zweiten Additionseingang der Additionsstufen (4) und (5) verbunden ist.

Im symmetrischen Betrieb, wenn sich zwischen den Ausgangsanschlüssen (7) und (8) eine potentialfrei angeschlossene Last befindet, ist es offensichtlich, daß sich die Magnetfelder der Spulen N1 und N2 aufheben und N3 somit stromlos bleibt, sodaß am Ausgang des I/U- Wandlers auch keine Spannung entstehen kann. Am den Ausgangsanschlüssen stellt sich eine Spannung von 2∗E∗V ein.

Wird nun zum Beispiel eine Ausgangsader kurzgeschlossen, so steigt der Strom in der kurzgeschlossenen Windung an. Damit sind die Ströme in N1 und N2 nicht mehr gleich und in N3 fließt ein Strom, der durch den I/U- Wandler in eine Spannung UH gewandelt wird. Bei entsprechender Polarität sorgt diese Spannung dafür, daß die Spannung an der kurzgeschlossenen Wicklung reduziert und an der anderen Wicklung um diesen reduzierten Betrag angehoben wird.

Die Funktion der Schaltung wird nun anhand eines einseitigen Ausgangskurzschlusses erläutert . Hierzu ist in Figur 2 das Blockschaltbild aus Figur 1 um die Innenwiderstände RI der Spulen N1 und N2 sowie einen einseitig mit Masse verbundenen Lastwiderstand RL erweitert worden. Mit der für die weitere Betrachtung nicht relevanten Vereinfachung einer Stufenverstärkungsbetrag von 1V/E für die Verstärker (2) und (3) sowie einer Eingangsspannung UE als Eingangsgröße ergeben sich die folgenden Berechnungen:

$$I1 = ( UE + UH ) / ( RI + RL ) \tag{1}$$

$$I2 = (-UE + UH ) / RI \tag{2}$$

$$I3 = I1 + I2 \tag{3}$$

$$UH = I3 * VIU \tag{4}$$

$$UA - I1 * RL \tag{5}$$

Es folgt aus (1), (2), (3) und (4)

$$UH = UE * (- VIU*RL /( RI*(RL+RI)-VIU*2*RI+RL)) \tag{6}$$

für sehr große VIU gilt dann:

$$UH = UE * RL /( 2*RI + RL ) \tag{7}$$

aus (7), (1) und (5) folgt dann:

$$UA = UE * 2 * RL/ (RL +2 * RI)$$

Dieser Wert entspricht einer Stufenverstärkung von 2, reduziert um den Spannungsabfall an den Innenwiderständen der beiden Spulenwicklungen .

Bei Kurzschluß des anderen Ausgangs ergibt sich an dessen komplementären Ausgang der gleiche Spannungsbetrag mit entgegengesetzter Phasenlage.

Da in allen diesen Betriebsfällen sich die Magnetfelder der Spulen N1 und N2 praktisch vollständig aufheben, kann die Symmetrierdrossel sehr klein ausgeführt werden. Weiterhin wird der Kern der Drossel magnetisiert, so daß auch keine Verzerrungsprodukte entstehen können.

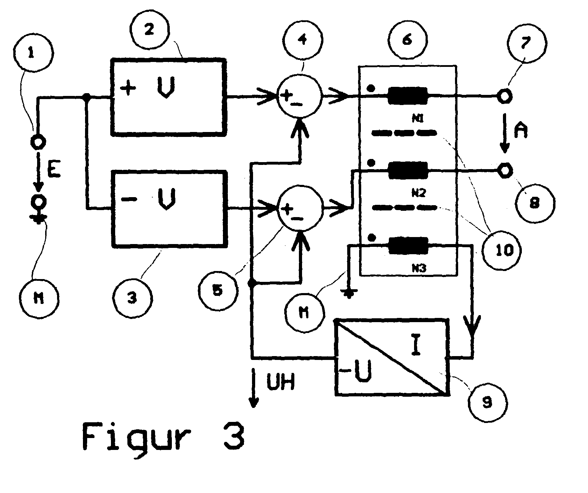

Figur 3 zeigt eine Ausführungsvariante, bei der die Additionsstufen durch Subtrahierpunkte ersetzt wurden, und das Ausgangssignal des I/U- Wandlers invertiert ist.

Es ist möglich und sinnvoll, die Funktionen von Verstärkung und Summierung bzw. Subtrahierung in einer Schaltungsbaugruppe, z. Beispiel einem entsprechend beschalteten Operationsverstärker, zu vereinigen. In diesen Fällen wird der Gesamtschaltungaufwand verringert.

In die Widerstandsunsymmetrie der Schaltung gehen die verstärkungsbestimmenden Widerstände der Additionspunkte (4,5) bezüglich ihrer UH-Eingänge ein. Bei entsprechender Schaltungswahl sind dies insgesamt nur 4 Widerstände.

In die Spannungsunsymmetrie der Schaltung gehen die verstärkungsbestimmenden Widerstände der Additionspunkte (4) und (5) bezüglich ihrer V- Eingänge sowie die Verstärkungstoleranz der beiden Verstärkerstufen (2,3) ein. Bei entsprechender Schaltungswahl sind dies insgesamt nur 6 Widerstände.

Die Ausgangsrauschspannung des I/U- Wandlers geht in keinem Betriebsfall in die Ausgangsrauschspannung der Gesamtschaltung ein. Im symmetrischen Betrieb wird die Rauschspannung durch die beiden Additionsstufen als Gleichtaktsignal auf die Ausgänge gegeben und in der Eingangsstufe eines nachfolgenden Gerätes um dessen Eingangsunsymmetriedämpfung gedämpft.

Im Betrieb bei unsymmetrischer Last entsteht an der kurzgeschlossenen Ausgangsübertragerwicklung eine Rauschspannung, die in der anderen, nicht kurzgeschlossenen Spule eine Rauschspannung induziert, die der an diesem, nicht kurzgeschlossenen Ausgang und vom I/U- Wandler stammenden Rauschspannung entgegengesetzt ist.

## Patentansprüche

1.  Schaltungsanordnung mit einem unsymmetrischen Eingang (E) über den Eingangsanschlüssen (1,M) und einem symmetrischen Spannungsausgang A über den Ausgangsanschlüssen (7,8) dessen Eingangsanschluß (1) mit dem Eingang eines nichtinvertierenden Verstärkers (2) mit dem Verstärkungsmaß V verbunden ist dessen Ausgang mit dem ersten Additionseingang einer ersten Additionsstufe (4) verbunden ist deren Ausgang mit dem ersten Anschluß einer ersten Wicklung (N1) einer Symmetrierdrossel (6) verbunden ist deren zweiter Anschluß den ersten Ausgangsanschluß (7) der Schaltung bildet und dessen Eingangsanschluß (1) ebenfalls mit dem Eingang eines invertierenden Verstärkers (3) mit dem Verstärkungsmaß -V verbunden ist dessen Ausgang mit dem ersten Additionseingang einer zweiten Additionsstufe (5) verbunden ist deren Ausgang mit dem ersten Anschluß einer zweiten Wicklung (N2) einer Symmetrierdrossel verbunden ist deren zweiter Anschluß den zweiten Ausgangsanschluß (8) der Schaltung bildet
    **dadurch gekennzeichnet,**
    daß auf der Drossel (6) eine dritte Wicklung (N3) aufgebracht ist, deren erster Anschluß mit Masse und deren zweiter Anschluß mit dem Stromeingang eines Strom/Spannungs- Wandlers (9) verbunden ist, dessen Ausgang mit dem jeweils 2. Additionseingang der Additionsstufen (4,5) verbunden ist.

2.  Schaltungsanordnung nach Anspruch 1, dadurch gekennzeichnet, daß der Übertragungsfaktor des Strom/Spannungswandlers so gewählt ist, daß die Ströme in der ersten und zweiten Wicklung (N1,N2) der Symmetrierdrossel auch bei Kurzschluß eines Ausgangsanschlusses mit Masse gleich oder annähernd gleich sind.

3.  Schaltungsanordnung nach Anspruch 1 oder 2, dadurch gekennzeichnet, daß statt der Additionsstufen jeweils eine Subtraktionsstufe verwendet wird und das Ausgangssignal des I/U- Wandlers invertiert ist.

4.  Schaltungsanordnung nach einem der Ansprüche 1 bis 3 dadurch gekennzeichnet, daß die erste und zweite Wicklung (N1,N2) der Symmetrierdrossel des Übertragers bifilar ausgeführt werden.

5.  Schaltungsanordnung nach einem der Ansprüche 1- 4,dadurch gekennzeichnet, daß der Übertrager einen magnetisierbaren Kern (10) besitzt.

6.  Schaltungsanordnung nach einem der vorangegangenen Ansprüche, dadurch gekennzeichnet, daß die Funktion der Additions-, bzw. Subtraktionsstufen (4) und des nichtinvertierenden Verstärkers (2) in einer Schaltungsstufe realisiert werden.

7.  Schaltungsanordnung nach einem der vorangegangenen Ansprüche, dadurch gekennzeichnet, daß die Funktion der Additions-, bzw. Subtraktionsstufen (5) und des invertierenden Verstärkers (3) in einer Schaltungsstufe realisiert werden.

8.  Schaltungsanordnung nach einem der Ansprüche 6 und 7 dadurch gekennzeichnet, daß diese Schaltungsstufe durch einen beschalteten Operationsverstärker realisiert wird.

9.  Schaltungsanordnung nach einem der vorangegangenen Ansprüche, dadurch gekennzeichnet, daß die Eingangsgröße des Eingangs (E) eine Spannung ist.

10. Schaltungsanordnung nach einem der Ansprüche 1-8, dadurch gekennzeichnet, daß die Eingangsgröße des Eingangs (E) ein Strom ist.

## Claims

1. A circuit arrangement having an asymmetrical input (E) by way of the input terminals (1, M) and a symmetrical voltage output A by way of the output terminals (7, 8), whose input terminal (1) is connected to the input of a non-inverting amplifier (2) of a gain V, whose output is connected to the first addition input of a first addition stage (4) whose output is connected to the first terminal of a first winding (N1) of a balancing choke (6) whose second terminal forms the first output terminal (7) of the circuit and whose input terminal (1) is also connected to the input of an inverting amplifier (3) of the gain -V, whose output is connected to the first addition input of a second addition stage (5) whose output is connected to the first terminal of a second winding (N2) of a balancing choke whose second terminal forms the second output terminal (8) of the circuit. characterised in that disposed on the choke (6) is a third winding (N3) whose first terminal is connected to earth and whose second terminal is connected to the current input of a current/voltage converter (9) whose output is connected to the respective second addition input of the addition stages (4, 5).

2. A circuit arrangement according to claim 1 characterised in that the transmission factor of the current/voltage converter is so selected that the currents in the first and second windings (N1, N2) of the balancing choke are equal or approximately equal even in the event of short-circuit of an output terminal to earth.

3. A circuit arrangement according to claim 1 or claim 2 characterised in that instead of the addition stages a respective subtraction stage is used and the output signal of the I/U-converter is inverted.

4. A circuit arrangement according to one of claims 1 to 3 characterised in that the first and second windings (N1, N2) of the balancing choke of the transformer are of a bifilar configuration.

5. A circuit arrangement according to one of claims 1 to 4 characterised in that the transformer has a magnetisable core (10).

6. A circuit arrangement according to one of the preceding claims characterised in that the function of the addition or subtraction stages (4) respectively and the non-inverting amplifier (2) are implemented in a circuit stage.

7. A circuit arrangement according to one of the preceding claims characterised in that the function of the addition or subtraction stages (5) respectively and the non-inverting amplifier (3) are implemented in a circuit stage.

8. A circuit arrangement according to one of claims 6 and 7 characterised in that said circuit stage is implemented by a wired operational amplifier.

9. A circuit arrangement according to one of the preceding claims characterised in that the input parameter of the input (E) is a voltage.

10. A circuit arrangement according to one of claims 1 to 8 characterised in that the input parameter of the input (E) is a current.

## Revendications

1. Circuit comprenant une entrée asymétrique (E) par l'intermédiaire des connexions d'entrée (1, M) et une sortie de tension symétrique A par l'intermédiaire des connexions de sortie (7, 8), dont la connexion d'entrée est reliée à l'entrée d'un amplificateur non-inverseur (2) ayant le coefficient d'amplification V, et dont la sortie est reliée à la première entrée d'addition d'un premier étage additionneur (4) dont la sortie est reliée à la première connexion d'un premier enroulement (N1) d'une bobine d'équilibrage (6), dont la deuxième connexion forme la première connexion de sortie (7) du circuit, et dont la connexion d'entrée (1) est de même reliée à l'entrée d'un amplificateur inverseur (3) ayant un coefficient d'amplification (V, et dont la sortie est reliée à la première entrée d'addition d'un deuxième ét)age additionneur (5) dont la sortie est reliée à la première connexion d'un deuxième enroulement (N2) d'une bobine d'équilibrage, dont la deuxième connexion forme la deuxième connexion de sortie (8) du circuit, **CARACTERISE** en ce que, sur la bobine (6) est prévu un troisième enroulement (N3) dont la première connexion est reliée à la masse et dont la deuxième connexion est reliée à l'entrée de courant d'un convertisseur courant/ tension (9) dont la sortie est reliée à la deuxième entrée d'addition de chacun des étages d'addition (4, 5).

2. Circuit selon la revendication 1, **caractérisé** en ce que le facteur de transmission du convertisseur courant/ tension est choisi de manière que les courants dans les premier et deuxième enroulements (N1, N2) de la bobine d'équilibrage soient identiques ou presque identiques, même en cas de mise en court-circuit d'une connexion de sortie avec la masse.

3. Circuit selon la revendication 1 ou 2, **caractérisé** en ce qu'en remplacement d'un des étages additionneurs, on utilise un étage soustracteur et le signal de sortie du convertisseur I/U est inversé.

4. Circuit selon une des revendications 1 à 3, **caractérisé** en ce que les premier et deuxième enroulements (N1, N2) de la bobine d'équilibrage du transmetteur sont réalisés sous une forme bifilaire.

5. Circuit selon une des revendications 1 à 4, **caractérisé** en ce que le transmetteur possède un noyau magnétisable (10).

6. Circuit selon une des revendications précédentes, **caractérisé** en ce que la fonction des étages additionneurs ou soustracteurs (4) et de l'amplificateur non-inverseur (2) sont réalisés dans un étage de commutation.

7. Circuit selon une des revendications précédentes, **caractérisé** en ce que la fonction des étages additionneurs ou soustracteurs (5) et de l'amplificateur non-inverseur (3) sont réalisés dans un étage de commutation.

8. Circuit selon une des revendications 6 et 7, **caractérisé** en ce que cet étage de commande est réalisé par un amplificateur opérationnel câblé.

9. Circuit selon une des revendications précédentes, **caractérisé** en ce que la grandeur d'entrée de l'entrée (E) est une tension.

10. Circuit selon une des revendications 1 à 8, **caractérisé** en ce que la grandeur d'entrée de l'entrée (E) est un courant.

Figur 1

Figur 2

Figur 3